# EUROPEAN PATENT SPECIFICATION

(11) **EP 4 351 832 B1**
(45) Date of publication and mention of the grant of the patent: **04.11.2026**
(21) Application number: 22741062.8
(22) Date of filing: 07.06.2022
(51) Int. Cl.: H05K 3/3465, B23K 35/02, B23K 35/26, C22C 13/00, C22C 13/02

(54) **HIGH RELIABILITY LEAD-FREE SOLDER PASTES WITH MIXED SOLDER ALLOY POWDERS**
HOCHZUVERLÄSSIGE BLEIFREIE LOTPASTEN MIT GEMISCHTEN LOTLEGIERUNGSPULVERN
PÂTES À BRASER SANS PLOMB DE HAUTE FIABILITÉ AVEC POUDRES MIXTES D'ALLIAGE DE BRASURE

(30) Priority: 11.06.2021 US 202163209585 P
(43) Date of publication of application: 17.04.2024
(73) Proprietor: Indium Corporation, Utica, New York 13502 (US)
(72) Inventor: GENG, Jie, Utica, NY 13502 (US); ZHANG, Hongwen, Utica, NY 13502 (US)
(74) Representative: Barker Brettell LLP
(86) International application number: PCT/US2022/032552
(87) International publication number: WO 2022/261130

(56) References cited:
- EP-A1- 2 468 450
- EP-A1- 2 671 667
- EP-A1- 3 708 290
- WO-A1-2005/099961
- WO-A1-2017/192517
- JP-A- 2018 058 090
- US-A1- 2016 279 741

## Description

### Cross-Reference to Related Applications

The present application claims the benefit of United States Provisional Patent Application Number 63/209,585 filed on June 11, 2021 and titled "High Reliability Lead-Free Solder Pastes with Mixed Solder Alloy Powders".

### Description of the Related Art

Lead (Pb) generated by the disposal of electronic assemblies is considered hazardous to the environment and human health. Regulations increasingly prohibit the use of Pb-based solders in the electronic interconnection and electronic packaging industries. The Restriction of Hazardous Substances (RoHS) directive of implemented in the European Union in July 2006 has led to replacement of Pb solder alloys with Pb-free solder alloys. SnAgCu ("SAC") solder alloys, such as Sn3.0Ag0.5Cu (SAC305) and Sn3.8Ag0.7Cu (SAC387), have become mainstream lead-free solders that are widely used in portable. These solders typically serve operation temperatures of 125°C and below, and they are widely used in computing, portable, and/or mobile electronics. Emerging automotive electronics demand service temperatures up to 150°C for devices used under-the-hood. Service temperatures below 125°C are still lean to compartment devices, but desiring longer service life than the mainstream SAC305.

For such harsh electronics environments, the traditional binary or ternary lead-free Sn-rich solder alloys are not reliable enough to survive. The higher the electronic device's operating temperature, the quicker the microstructure of the solder joint formed from the solder alloy coarsens and degrades. The recent development of high reliability lead-free Sn-rich solder alloys demonstrates that Sb plays a key role in improving the thermal fatigue resistance of solder joints in harsh thermal cycling or thermal shock conditions. In such alloys, 5.0wt% to 9.0 wt% Sb may be alloyed in order to optimize the volume fractions of fine SnSb intermetallic compound (IMCs) particles and balance the strength and the ductility of a solder joint formed from the solder alloy.

EP3708290 discloses a solder paste containing Sn-based powder, SnSb-based alloy powder with Sn and 10 mass% or more of Sb, and flux, where a liquidus temperature of the SnSb-based alloy powder is higher than a liquidus temperature of the Sn-based powder, and a content ratio of the Sn-based powder and the SnSb-based alloy powder is 75:25 to 95: 5. Ep '290 discloses a paste where the content ratio of the Sn-based powder to the SnSb-based alloy powder is 80:20 to 90:10.

WO 2005/099961 discloses a Pb-free, Bi-free solder alloy powder mixture made of two powders: a first higher melting point Sn or Sn alloy powder or Sn powder; and a second lower melting point Sn alloy powder or Sn powder, which melt to form a final solder alloy containing 0.1-5 % Cu and/or 0.1-10 % Ag and/or 0.1-5 % Sb, the remainder being Sn. WO '961 also discloses a method of solder alloy powder production. The method comprises mixing a first Pb-free, Bi-free solder alloy powder and a second Pb-free, Bi-free alloy powder, which has a lower melting point than the first solder alloy powder, the two being meltable on soldering to produce a final alloy containing 0.1-5 % Cu and/or 0.1-10 % Ag and/or 0.1-5 % Sb, the remainder being Sn.

JP 2018058090 discloses a solder paste made by mixing solder alloy powders and a flux. The solder alloy powders include first solder alloy powders and second solder alloy powders having different compositions, the first solder alloy powders contain 0.1 mass% or more and 4.0 mass% or less Ag, 0.1 mass% or more and 0.8 mass% or less Cu, 0 mass% or more and 6.0 mass% or less Bi, 0 mass% or more and 2.5 mass% or less Sb and the balance Sn, and the second solder alloy powders contain 0.1 mass% or more and 4.0 mass% or less Ag, 0.1 mass% or more and 0.8 mass% or less Cu, 0 mass% or more and 6.0 mass% or less Bi, more than 2.5 mass% and 16 mass% or less Sb and the balance Sn, and the content of Bi in the second solder alloy powders is equal to or less than the content of Bi in the first solder alloy powders.

### Summary

According to a first aspect of the present invention, there is provided a solder paste as defined in independent claim 1. According to a second aspect of the present invention, there is provided a method as defined in independent claim 9. Some optional or preferred features are disclosed in the dependent claims.

Some implementations of the disclosure are directed to a solder paste including two or more metal solder powders and flux, where one of the solder powders can have a lower melting temperature than the other, comparable to or slightly lower than the melting temperature of traditional SnAgCu solder alloys, and the other solder powder can have a melting temperature comparable to or higher than traditional SnAgCu solder alloys because of the addition of Sb. The solder paste can reduce the peak reflow temperature, widen the process window, decrease voiding, and/or maintain comparable reliability or even improve the reliability of the high-reliability single powder counterpart paste.

According to the invention, the solder paste consists essentially of: 10 wt% to 90 wt% of a first solder alloy powder; 10 wt% to 90 wt% of a second solder alloy powder, and the second solder alloy powder having a lower solidus temperature than the first solder alloy powder; and flux.

In some implementations, the solder paste consists essentially of 40 wt% to 90 wt% of the first solder alloy powder, 10 wt% to 60 wt% of the second solder alloy powder, and the flux.

In some implementations, the first solder alloy powder has a solidus temperature of 210°C to 245°C; and the second solder alloy powder has a solidus temperature of 200°C to 217°C.

According to the invention, the first solder alloy powder consists of 1.5-4.0 wt% of Ag; 0.5-1.2 wt% of Cu; 3.0-6.5 wt% of Sb; 0.2-7.0 wt% of Bi; 0.1-3.5 wt% of In; optionally, 0.001-3.0 wt% of Ni, Co, Mn, P, or Zn; and a remainder of Sn. In some examples not forming part of the present invention, the first solder alloy powder is: 2-10 wt% of Sb; optionally, 0.001-3.0 wt% of Ni, Co, Mn, P, or Zn; and a remainder of Sn; 1.5-4.0 wt% of Ag; 0.5-1.2 wt% of Cu; 3.5-6.5 wt% of Sb; optionally, 0.001-3.0 wt% of Ni, Co, Mn, P, or Zn; and a remainder of Sn; 1.5-4.0 wt% of Ag; 0.5-1.2wt% of Cu; 3.5-6.5wt% of Sb; 0.2-7.0 wt% of Bi; optionally, 0.001-3.0 wt% of Ni, Co, Mn, P, or Zn; and a remainder of Sn; 1.5-4.0 wt% of Ag; 0.5-1.2 wt% of Cu; 9-15 wt% of Sb; optionally, 0.001-3.0 wt% of Ni, Co, Mn, P, or Zn; and a remainder of Sn; or 1.5-4.0 wt% of Ag; 0.5-1.2 wt% of Cu; 9-15 wt% of Sb; 0.1-3.5 wt% of In; optionally, 0.001-3.0 wt% of Ni, Co, Mn, P, or Zn; and a remainder of Sn.

In some examples not forming part of the present invention, the first solder powder is 1.5-4.0 wt% of Ag; 0.5-1.2 wt% of Cu; 9-15 wt% of Sb; optionally, 0.001-3.0 wt% of Ni, Co, Mn, P, or Zn; and a remainder of Sn; or 1.5-4.0 wt% of Ag; 0.5-1.2 wt% of Cu; 9-15 wt% of Sb; 0.1-3.5 wt% of In; optionally, 0.001-3.0 wt% of Ni, Co, Mn, P, or Zn; and a remainder of Sn.

According to the invention, the second solder alloy powder is: 1.5-4.0wt% Ag, 0.5-1.2wt%Cu, 1.0-7.0wt% Bi, and a remainder of Sn. In some examples not forming part of the present invention, the second solder alloy powder is: 1.5-4.0wt% Ag, 0.5-1.2wt%Cu, and a remainder of Sn.

In some implementations, the first solder alloy powder comprises 0.001-3.0 wt% of Ni, Co, Mn, P, or Zn.

In some implementations, the first solder alloy is 89Sn3.8Ag0.7Cu3.5Sb0.5Bi2.5In or 86.7Sn3.2Ag0.7Cu5.5Sb3.2Bi0.5In0.2Ni. In some examples not forming part of the present invention, the first solder alloy powder is 95Sn-5Sb, 90.6Sn3.2Ag0.7Cu5.5Sb0.01Ni, 89.3Sn3.8Ag0.9Cu5.5Sb0.5In, 89.7Sn3.8Ag1.2Cu3.8Sb1.5Bi, 85.1Sn3.2Ag0.7Cu11Sb, or 84.6Sn3.2Ag0.7Cu11Sb0.5In.

In some implementations, the second solder alloy powder is 91.0Sn2.5Ag0.5Cu6.0Bi, 93.5Sn3.0Ag0.5Cu3.0Bi, 93.5Sn3.0Ag0.5Cu6.0Bi. In some examples not forming part of the present invention, the second solder alloy powder is 96.5Sn3.5Ag0.5Cu.

According to the invention, a method comprises: applying a solder paste between two components to form an assembly, the solder paste consisting essentially of: 10 wt% to 90 wt% of a first solder alloy powder, the first solder alloy powder consisting of 1.5-4.0 wt% of Ag; 0.5-1.2 wt% of Cu; 3.0-6.5 wt% of Sb; 0.2-7.0 wt% of Bi; 0.1-3.5 wt% of In; optionally, 0.001-3.0 wt% of Ni, Co, Mn, P, or Zn; and a remainder of Sn; 10 wt% to 90 wt% of a second solder alloy powder, the second solder alloy powder consisting of 1.5-4.0 wt% of Ag, 0.5-1.2 wt% of Cu, 1.0-7.0 wt% of Bi, and a remainder of Sn, and the second alloy having a lower solidus temperature than the first alloy; and flux; and reflow soldering the assembly to form a solder joint from the solder paste.

In some implementations, reflow soldering the assembly to form the solder joint, comprises: reflow soldering the assembly at a peak temperature lower than required to form a solder joint from a solder paste consisting of the first solder alloy powder and the flux. For example, while the solder paste including the mixed solder alloy powder and flux may be reflow soldered at a temperature below 245°C (e.g., about 240°C), the peak temperature required to form solder joint from a solder paste consisting of the first solder alloy powder and the flux may be above 245°C, above 250°C, above 255°C, or even higher. In some implementations, the assembly is reflow soldered at a peak temperature below 245°C. In some implementations, the assembly is reflow soldered at a peak temperature from about 240°C to below 245°C. In some implementations, the assembly is reflow soldered at a peak temperature of about 240°C or lower. In some implementations, the assembly is reflow soldered at a peak temperature of about 235°C to about 240°C.

In one example not forming part of the present invention, a solder joint is formed by a process, the process comprising: applying a solder paste between two components to form an assembly, the solder paste consisting essentially of: 10 wt% to 90 wt% of a first solder alloy powder, the first solder alloy powder consisting of a Sn-Sb alloy, a Sn-Ag-Cu-Sb alloy, a Sn-Ag-Cu-Sb-In alloy, a Sn-Ag-Cu-Sb-Bi alloy, or Sn-Ag-Cu-Sb-Bi-In alloy; 10 wt% to 90 wt% of a second solder alloy powder, the second solder alloy powder consisting of an Sn-Ag-Cu alloy or Sn-Ag-Cu-Bi alloy, and the second alloy having a lower solidus temperature than the first alloy; and flux; an reflow soldering the assembly to form the solder joint from the solder paste
Other features and aspects of the disclosed technology will become apparent from the following detailed description, taken in conjunction with the accompanying drawings, which illustrate, by way of example, the features in accordance with implementations of the disclosed technology. The summary is not intended to limit the scope of any inventions described herein, which are defined by the claims and equivalents.

### Brief Description of the Drawings

The technology disclosed herein, in accordance with one or more various embodiments, is described in detail with reference to the included figures. The figures are provided for purposes of illustration only and merely depict example implementations.
FIG. 1A is a plot showing the void percentage of three solder joints formed after reflow with the same reflow profile having a peak temperature of 240°C.
FIG. 1B is a plot showing the bond shear strength in megapascals of the three solder joints of FIG. 1A.
FIG. 2 is a plot showing the void percentage of six solder joints formed after reflow with the same reflow profile having a peak temperature of 240°C.
FIG. 3 illustrates the bond shear strength, at a temperature range from 25°C to 175°C, of Cu-Cu joints made from three different solder pastes, and reflowed under the same profile.
FIG. 4A shows a cross-section of a solder joint formed from a mixed alloy powder solder paste after thermal cycling tests, in accordance with implementations of the disclosure.
FIG. 4B shows a cross-section of a solder joint formed from a single alloy powder solder paste after thermal cycling tests.
FIG. 5 is a plot showing the voiding percentage of nine solder joints formed after reflow with the same reflow profile having a peak temperature of 240°C.
FIG. 6 is a plot showing the voiding percentage of seven solder joints of an MLF68 component on a test board, the solder joints formed after reflow with the same reflow profile having a peak temperature of 240°C.
FIG. 7 shows the cross sections of seven solder joints after 2000 cycles of a thermal cycling test (-40/125°C).

The figures are not intended to be exhaustive or to limit the invention to the precise form disclosed. It should be understood that the invention can be practiced with modification and alteration, and that the disclosed technology be limited only by the claims.

### Detailed Description

As discussed above, 5.0 wt% to 9.0 wt% Sb has been added to SnAgCu solders to significantly improve reliability in high temperature, harsh electronic environments. However, alloying 5.0-9.0 wt% Sb to typical SnAgCu solder alloys may widen the pasty range (i.e., range between solidus and liquidus temperatures of alloy) and increase the melting point of the solder alloy by about 8 to 11 degrees Celsius compared to the commonly used SnAgCu solders, which have a melting temperature around 217°C. Due to the increase in melting temperature of SnAgCuSb, SnAgCuSbIn or SnAgCuBiSb based solder alloys, the traditional SAC reflow temperature of 235° to 240°C has to be increased by at least 10°C to 245-250 °C. This may narrow the process window when soldering with the Sb-containing SnAgCuSb alloy because some of the printed circuit board assembly (PCBA) components cannot withstand the increasing reflow temperature. In addition to the rising process temperature, the high reliability Sn-rich solder alloys typically show worse voiding performance than SnAgCu alloys using the traditional SnAgCu process profile, possibly because of the wider pasty range from adding Sb. In summary, although adding Sb in an amount of 5.0 to 9.0wt% to an SnAgCu solder alloy may significantly improve reliability, it will increase the solder alloy's melting temperature and widen the pasty range, which may lead to a higher reflow peak temperature, a narrower process window, and/or poor voiding performance compared to the mainstream lead-free solders such as SAC305 and SAC387.

To address these challenges, implementations of the present invention are directed to a novel solder paste including two or more selected metal solder powders and a flux, where the solder paste is targeted at (1) reducing the reflow peak temperature, (2) widening the process window, (3) decreasing voiding, and/or (4) maintaining comparable reliability or even improving the reliability of the high-reliability single powder counterpart paste. One of the solder powders may have a lower melting temperature than the other, comparable to or slightly lower than the melting temperature of traditional SnAgCu solder alloys, and the other solder powder may have a melting temperature comparable to or higher than traditional SnAgCu solder alloys because of the addition of Sb. For example, in one implementation of a solder paste having at least two solder alloy powders, a first solder alloy powder has a higher solidus temperature that may range from 210 to 245 °C, and the second solder alloy powder has a lower solidus temperature that may range from 200 to 217 °C.

In some implementations not forming part of the present invention, the higher melting temperature solder alloy may comprise SnSb, SnAgCuSb, SnAgCuSbIn, SnAgCuBiSb, SnAgCuBiSbln, or variations thereof. In some examples, additives of Bi, In, Ni and/or Co may be included in the higher melting temperature solder alloy to enhance its ductility or improve wetting performance. Table 1 shows compositions of example higher melting temperature solder alloys (depicted as Alloys A to D, and I to K) as compared to traditional SnAgCu alloys (depicted as Alloys E to H). The higher melting temperature solder alloys in accordance with the disclosure may provide improved reliability and a higher melting temperature compared to the traditional Sn-rich SnAgCu solder alloys.

**Table 1**

| **Alloy** | **Sn** | **Ag** | **Cu** | **Sb** | **Bi** | **In** | **Ni** |
|---|---|---|---|---|---|---|---|
| **A** | 86.70 | 3.20 | 0.70 | 5.50 | 3.20 | 0.50 | 0.20 |
| **B** | 90.59 | 3.20 | 0.70 | 5.50 | | | 0.01 |
| **C** | 89.30 | 3.80 | 0.90 | 5.50 | | 0.50 | |
| **D** | 89.00 | 3.80 | 0.70 | 3.50 | 0.50 | 2.50 | |
| **E** | 96.50 | 3.00 | 0.50 | | | | |
| **F** | 93.50 | 3.00 | 0.50 | | 3.00 | | |
| **G** | 90.50 | 3.00 | 0.50 | | 6.00 | | |
| **H** | 91.00 | 2.50 | 0.50 | | 6.00 | | |
| **I** | 95.00 | | | 5.00 | | | |
| **J** | 85.10 | 3.20 | 0.70 | 11.00 | | | |
| **K** | 84.60 | 3.20 | 0.70 | 11.00 | | 0.5 | |

To maintain good voiding performance and high reliability of the final solder joint, as well as a maximum process temperature of 245°C, the ratio of higher melting temperature solder alloy and the lower melting temperature solder alloy may be tuned. If the wt% of the lower solidus temperature solder alloy relative to the higher solidus temperature solder alloy is insufficient, the process temperature needed may be above 245°C. On the other hand, if the lower solidus temperature solder alloy is more than sufficient, the reliability of the solder joint may be compromised due to a shortage of the higher solidus temperature solder alloy. Therefore, the ratio of the first and the second solder alloys in the paste may need to be carefully designed so that both the high reliability performance and the low process temperature window will be satisfied. To this end, the higher solidus temperature solder powder comprises 10wt% to 90wt% of the solder paste, and the lower solidus temperature solder powder comprises 10wt% to 90wt% of the solder paste. In particular implementations, the higher solidus temperature solder powder may comprise 40wt% to 90wt% of the solder paste, and the lower solidus temperature solder powder may comprise 10wt% to 60wt% of the solder paste.

Table 2, below, illustrates example compositions of lead-free mixed solder powder pastes in accordance with the present invention. The first, higher solidus temperature and higher reliability solder alloy (Alloy#A in Table 1) is Sn3.2Ag0.7Cu5.55b3.2Bi0.5In0.2Ni, and the second, lower solidus temperature solder alloy is a SnAgCuBi solder alloy (either Alloy #H or #F in Table 1).

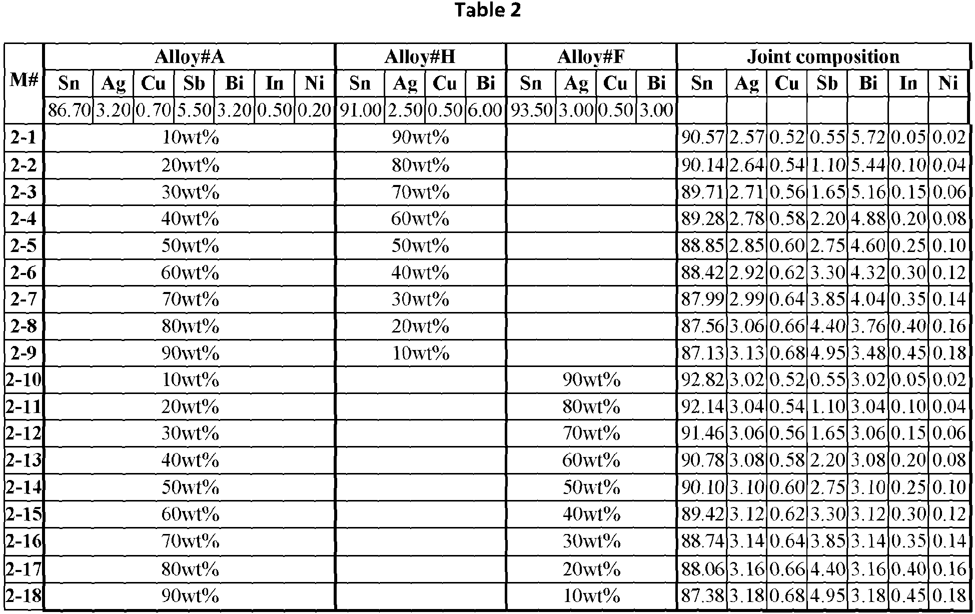

Table 3, below, illustrates example compositions of lead-free mixed solder powder pastes not forming part of the present invention. The first, higher solidus temperature and higher reliability solder alloy (Alloy#B in Table 1) is Sn3.2Ag0.7Cu5.5Sb0.01Ni, and the second, lower solidus temperature solder alloy is an SnAgCu solder alloy (Alloy#E) or SnAgCuBi solder alloy (Alloy#G).

**Table 3**

| | **Alloy#B** | | | | | **Alloy#E** | | | **Alloy#G** | | | | **Joint composition** | | | | | |
|---|---|---|---|---|---|---|---|---|---|---|---|---|---|---|---|---|---|---|
| **M#** | **Sn** | **Ag** | **Cu** | **Sb** | **Ni** | **Sn** | **Ag** | **Cu** | **Sn** | **Ag** | **Cu** | **Bi** | **Sn** | **Ag** | **Cu** | **Sb** | **Bi** | **Ni** |
| | 90.59 | 3.20 | 0.70 | 5.50 | 0.01 | 96.50 | 3.00 | 0.50 | 90.50 | 3.00 | 0.50 | 6.00 | | | | | | |
| **3-1** | 10wt% | | | | | 90wt% | | | | | | | 95.91 | 3.02 | 0.52 | 0.55 | | 0.00 |
| **3-2** | 20wt% | | | | | 80wt% | | | | | | | 95.32 | 3.04 | 0.54 | 1.10 | | 0.00 |
| **3-3** | 30wt% | | | | | 70wt% | | | | | | | 94.73 | 3.06 | 0.56 | 1.65 | | 0.00 |
| **3-4** | 40wt% | | | | | 60wt% | | | | | | | 94.14 | 3.08 | 0.58 | 2.20 | | 0.00 |
| **3-5** | 50wt% | | | | | 50wt% | | | | | | | 93.55 | 3.10 | 0.60 | 2.75 | | 0.01 |
| **3-6** | 60wt% | | | | | 40wt% | | | | | | | 92.95 | 3.12 | 0.62 | 3.30 | | 0.01 |
| **3-7** | 70wt% | | | | | 30wt% | | | | | | | 92.36 | 3.14 | 0.64 | 3.85 | | 0.01 |
| **3-8** | 80wt% | | | | | 20wt% | | | | | | | 91.77 | 3.16 | 0.66 | 4.40 | | 0.01 |
| **3-9** | 90wt% | | | | | 10wt% | | | | | | | 91.18 | 3.18 | 0.68 | 4.95 | | 0.01 |
| **3-10** | 10wt% | | | | | | | | 90wt% | | | | 90.51 | 3.02 | 0.52 | 0.55 | 5.40 | 0.00 |
| **3-11** | 20wt% | | | | | | | | 80wt% | | | | 90.52 | 3.04 | 0.54 | 1.10 | 4.80 | 0.00 |
| **3-12** | 30wt% | | | | | | | | 70wt% | | | | 90.53 | 3.06 | 0.56 | 1.65 | 4.20 | 0.00 |
| **3-13** | 40wt% | | | | | | | | 60wt% | | | | 90.54 | 3.08 | 0.58 | 2.20 | 3.60 | 0.00 |
| **3-14** | 50wt% | | | | | | | | 50wt% | | | | 90.55 | 3.10 | 0.60 | 2.75 | 3.00 | 0.01 |
| **3-15** | 60wt% | | | | | | | | 40wt% | | | | 90.55 | 3.12 | 0.62 | 3.30 | 2.40 | 0.01 |
| **3-16** | 70wt% | | | | | | | | 30wt% | | | | 90.56 | 3.14 | 0.64 | 3.85 | 1.80 | 0.01 |
| **3-17** | 80wt% | | | | | | | | 20wt% | | | | 90.57 | 3.16 | 0.66 | 4.40 | 1.20 | 0.01 |
| **3-18** | 90wt% | | | | | | | | 10wt% | | | | 90.58 | 3.18 | 0.68 | 4.95 | 0.60 | 0.01 |

Table 4, below, illustrates example compositions of lead-free mixed solder powder pastes in accordance with the disclosure. The first, higher solidus temperature and higher reliability solder alloys are Alloy #A, #J, and #K in Table 1, and the second, lower solidus temperature solder alloys are SnAgCuBi solder alloys (Alloy #F and #H). Of the higher solidus temperature and higher reliability solder alloys only Alloy #A is according to the present invention. From the lower solidus temperature solder alloys both Alloy #F and Alloy #H are according to the present invention.

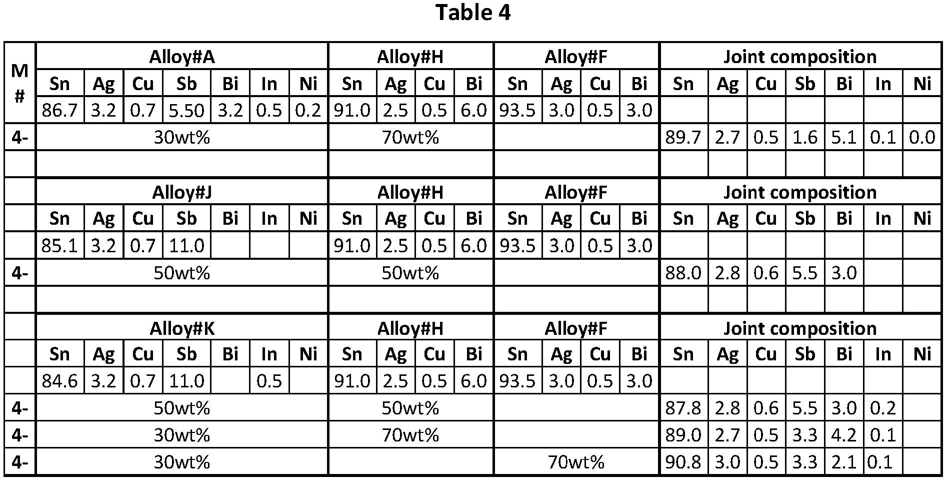

Table 5, below, lists the solidus and liquidus temperatures for single solder alloys (Alloy#A and H in Table 1) and eight alloys of mixed solder pastes (M#2-6 to 2-8 in Table 2 and M#4-1 to 4-5 in Table 4). The solidus and liquidus temperatures were measured by Differential Scanning Calorimeter (DSC) performed with TA Q2000 DSC.

**Table 5**

| | **Solidus, °C** | **Liquidus, °C** |
|---|---|---|
| **Alloy#A** | 214.38 | 228.75 |
| **Alloy#H** | 199.11 | 215.48 |
| **M#2-6** | 211.19 | 224.66 |
| **M#2-7** | 212.91 | 226.59 |
| **M#2-8** | 214.42 | 227.44 |
| **M#4-1** | 206.1 | 221.6 |
| **M#4-2** | 216.3 | 230.6 |
| **M#4-3** | 216.0 | 229.8 |
| **M#4-4** | 211.2 | 227.4 |
| **M#4-5** | 214.8 | 230.0 |

As depicted, mixing 40wt% Alloy#H into Alloy#A may reduce the solder joint melting point by 4°C, which demonstrates the feasibility of reflowing under a lower peak temperature as compared to a solder paste containing only Alloy#A.

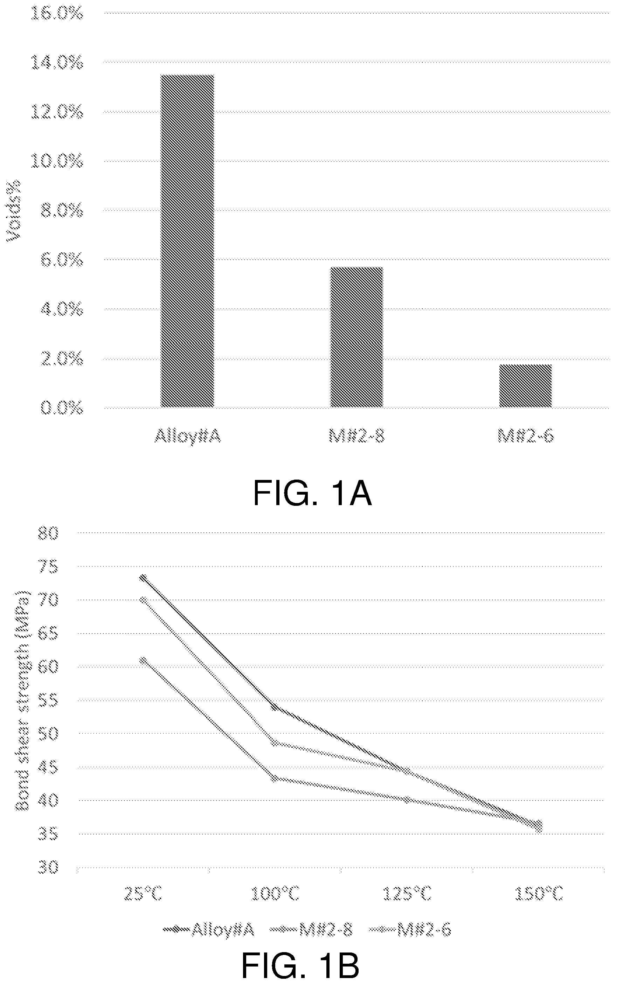

FIGs. 1A-1B are plots respectively showing the void percentage (FIG. 1A) and bond shear strength in megapascals (MPa) (FIG. 1B) of three solder joints formed after reflow with the same reflow profile having a peak temperature of 240°C. The three solder joints were formed using a single alloy (Alloy#A) solder paste and mixed solder pastes (M#2-6 and M#2-8 in Table 2). A 3mmX3mm Cu die was reflowed to solder onto an organic solderability preservatives (OSP) substrate to form die-attach solder joints. The voids percentage was measured by X-ray and the bond shear strength was captured at different temperatures with a CONDOR 250 XYZTEC shear tester.

Generally speaking, the higher shear strength of a solder joint suggests better reliability. As depicted by FIGs. 1A-1B, having a lower quantity of Alloy#A in M#2-6 resulted in better voiding performance (i.e., lower void percentage) while maintaining the high temperature (under 125°C and 150°C) bond shear strength compared to (1) the counterpart single alloy solder paste (Alloy#A) and (2) the mixed solder paste M#2-8. Considering the combination of both voiding performance and bond strength, M#2-6 (60wt% of Alloy#A and 40wt% of Alloy#H) outperformed M#2-8 (80wt% of Alloy#A and 20wt% of Alloy#H).

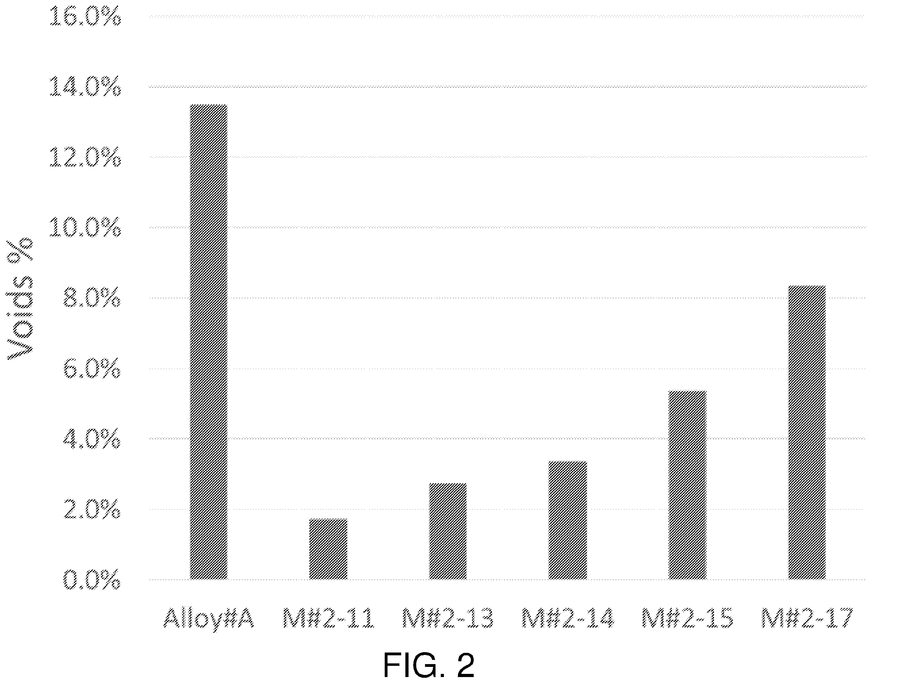

FIG. 2 is a plot showing the void percentage of six solder joints formed after reflow with the same reflow profile having a peak temperature of 240°C. The six solder joints were formed using a single alloy (Alloy#A) solder paste and five mixed solder pastes (M#2-11, M#2-13, M#2-14, M#2-15, and M#2-17 in Table 2). The trend of voiding performance with the quantity of the selected low solidus temperature solder alloy (#F) in the mixed solder paste (#A and #F) is recognized from the plot. The higher the quantity of alloy #F in the solder, the lower the voiding percentage. However, in order to maintain reliability, the mixing ratio of Alloy#A and #F may need to be maintained above a certain level.

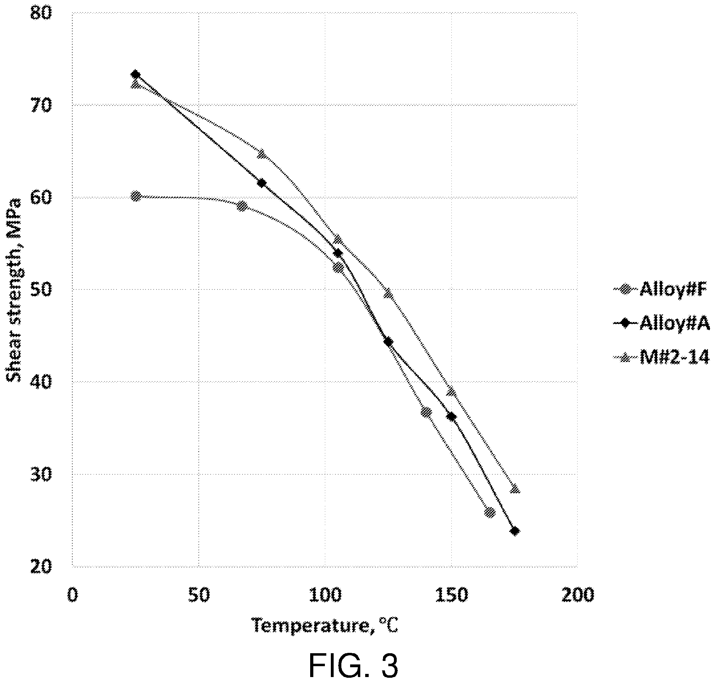

FIG. 3 illustrates the bond shear strength, at a temperature range from 25°C to 175°C, of Cu-Cu joints made from Alloy#A, #F and M#2-14, and reflowed under the same profile. The solder joint made from the mixed solder paste M#2-14 exhibited higher bond strength throughout the whole temperature range than both solder joints made from single alloy solder pastes (#A and #F), indicating better reliability. This demonstrated that a 50wt% to 50wt% mixing ratio of Alloy#A and Alloy#F not only improves the voiding performance but also enhances the bond shear strength and possibly the associated reliability.

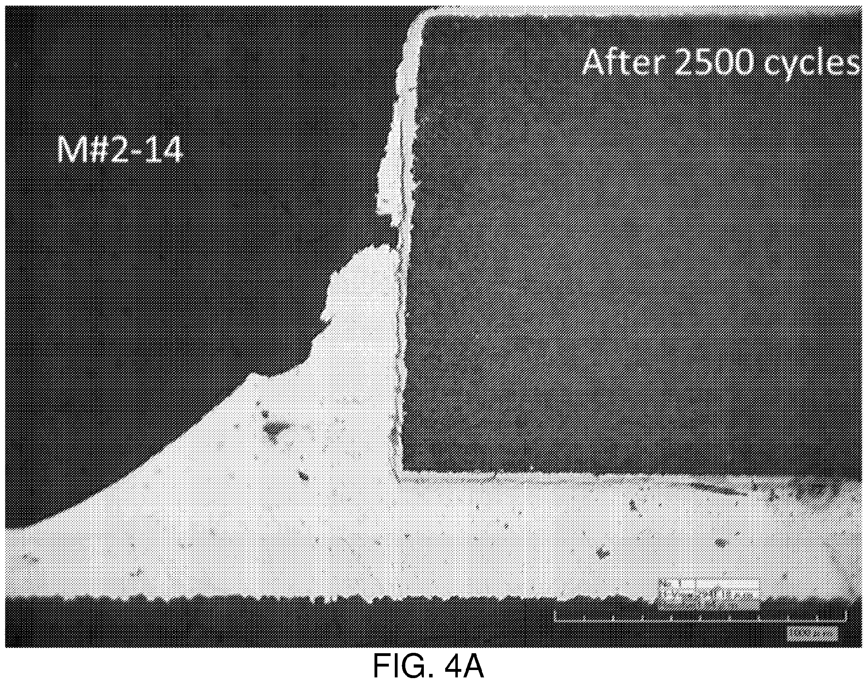

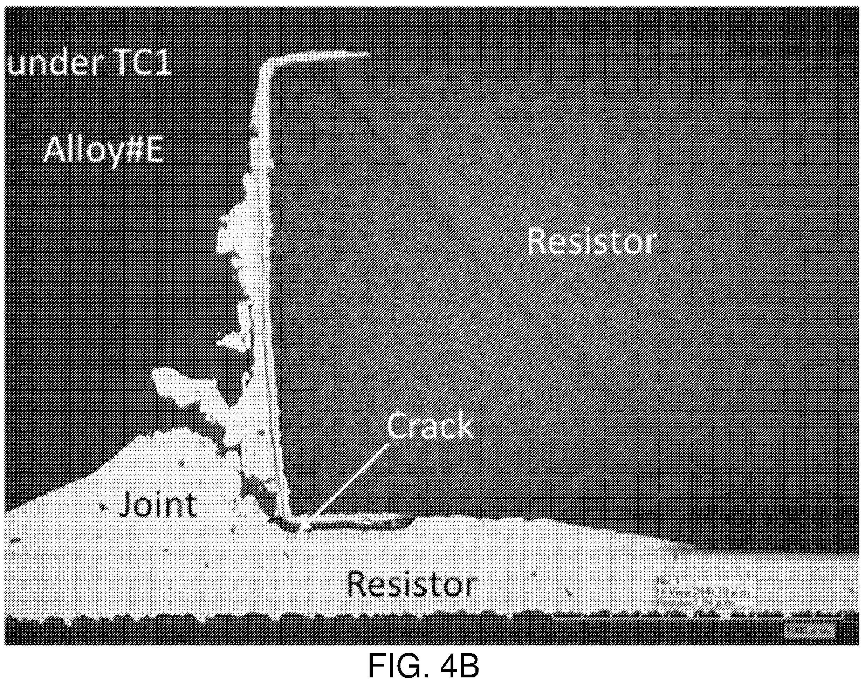

Thermal fatigue reliability of solder joints comprising embodiments of M#2-14, consisting of 50wt% Alloy#A and 50wt% Alloy#F, was evaluated using an accelerated thermal cycling (ATC) test with assembled chip resistor test boards. The assembled chip resistor test boards, which had two different sized resistors, 0603 and 0805, enabled electrical continuity testing, i.e., in-situ, continuous monitoring during thermal cycling. The nominal temperature cycling profiles for ATC were 1) from -40 to 125°C with a dwell time of 10 minutes at each extreme temperature (TC1), and 2) from -40 to 150°C with a dwell time of 10 minutes at each extreme temperature (TC2). The solder joints were monitored using a data logger that set a resistance increase of 50% as a failure criterion. There was no failure of any resistors after 4000 cycles under TC1 and after 2500 cycles under TC2. The cross section of solder joints after 2500 cycles under TC1 showed no obvious crack growth around the corner of the joint, where the strain is highest. The tests demonstrated that solder joints made of M#2-14 were much more thermally stable than the commonly used industry standard Alloy#E. FIGs. 4A-4B respectively show cross-sections of solder joints formed from M#2-14 (FIG. 4A) and Alloy#E (FIG. 4B) after 2500 cycles under TC1. The solder joint of Alloy#E exhibited severe cracking after 2500 cycles under TC1 while the solder joint of M#2-14 was nearly intact.

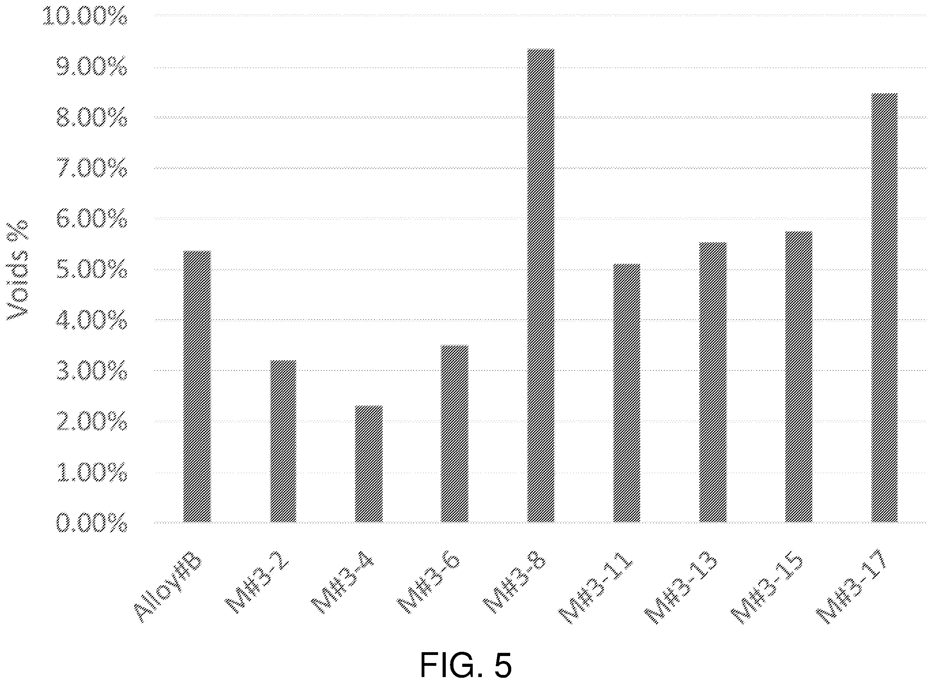

FIG. 5 is a plot showing the voiding percentage of nine solder joints formed after reflow with the same reflow profile having a peak temperature of 240°C. The nine solder joints were formed using a single alloy (Alloy#B) solder paste and eight mixed solder alloy pastes (M#3-2, M#3-4, M#3-6, M#3-8, and M#3-11, M#3-13, M#3-15, M#3-17 in Table 3). The plot shows that having a higher ratio of the lower solidus temperature solder alloy (#E or #G) relative to the higher solidus temperature solder alloy (#B) in the mixed solder alloy paste generally correlated with better voiding performance.

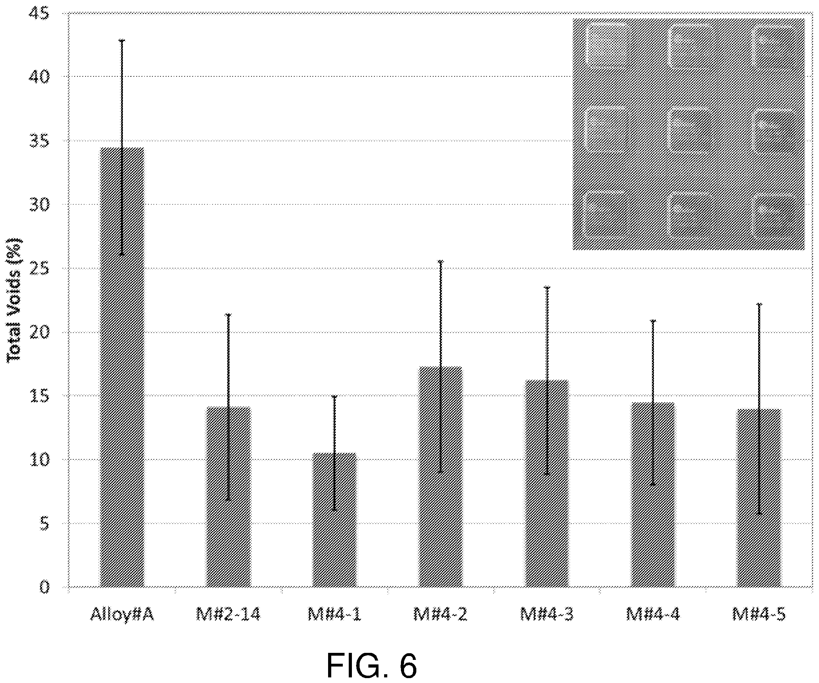

FIG. 6 is a plot showing the voiding percentage of seven solder joints formed after reflow with the same reflow profile having a peak temperature of 240°C. As depicted in the top right of FIG. 6, the solder joints were formed between a MicroLeadFrame^{®} component (MLF68) and a test board. The seven solder joints were formed using a single alloy (Alloy#A) solder paste and six mixed solder alloy pastes (M#2-14 in Table 2, and M#4-1 to 4-5 in Table 4). The plot shows that the mixed solder alloy pastes have better voiding performance than the single alloy solder paste. The plot also shows that having a higher ratio of the lower solidus temperature solder alloy (e.g., #F or #H) relative to the higher solidus temperature solder alloy (#A) in the mixed solder alloy paste generally correlated with better voiding performance.

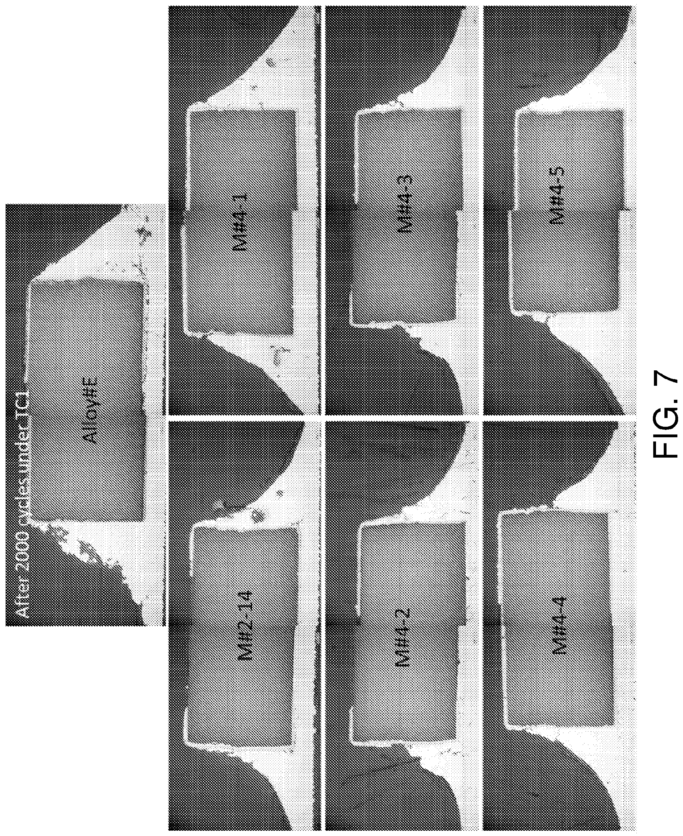

Thermal fatigue reliability of solder joints comprising Alloy#E (commonly used industry standard), M#2-14 and M#4-1 to 4-5 were evaluated using an ATC test, TC1 as defined above, with assembled chip resistor (1206 resistor) test boards. The cross sections of solder joints after 2000 cycles under TC1 were compared. FIG. 7 shows cross sections of solder joints formed from Alloy#E, M#2-14 and M#4-1 to 4-5 after 2000 cycles under TC1. The crack propagation shown in the cross sections demonstrates that solder joints made of mixed powder solder pastes in accordance with the disclosure were much more thermally stable than the commonly used industry standard Alloy#E.

While various embodiments of the disclosed technology have been described above, it should be understood that they have been presented by way of example only, and not of limitation.

Terms and phrases used in this document, and variations thereof, unless otherwise expressly stated, should be construed as open ended as opposed to limiting. As examples of the foregoing: the term "including" should be read as meaning "including, without limitation" or the like; the term "example" is used to provide exemplary instances of the item in discussion, not an exhaustive or limiting list thereof; the terms "a" or "an" should be read as meaning "at least one," "one or more" or the like.

The presence of broadening words and phrases such as "one or more," "at least," "but not limited to" or other like phrases in some instances shall not be read to mean that the narrower case is intended or required in instances where such broadening phrases may be absent.

## Claims

1. A solder paste, comprising:
solder powder consisting of:
10 wt% to 90 wt% of a first solder alloy powder, the first solder alloy powder consisting of 1.5-4.0 wt% of Ag; 0.5-1.2 wt% of Cu; 3.0-6.5 wt% of Sb; 0.2-7.0 wt% of Bi; 0.1-3.5 wt% of In; optionally, 0.001-3.0 wt% of Ni, Co, Mn, P, or Zn; and a remainder of Sn; and
10 wt% to 90 wt% of a second solder alloy powder, the second solder alloy powder having a lower solidus temperature than the first solder alloy powder, and the second solder alloy powder consisting of 1.5-4.0 wt% of Ag, 0.5-1.2 wt% of Cu, 1.0-7.0 wt% of Bi, and a remainder of Sn; and
flux.

2. The solder paste of claim 1, wherein
(i) the first solder alloy powder has a solidus temperature of 210°C to 245°C; and
(ii) the second solder alloy powder has a solidus temperature of 200°C to 217°C.

3. The solder paste of claim 1, wherein the first solder alloy powder is 1.5-4.0 wt% of Ag; 0.5-1.2 wt% of Cu; 3.0-6.5 wt% of Sb; 0.2-7.0 wt% of Bi; 0.1-3.5 wt% of In; 0.001-3.0 wt% of Ni, Co, Mn, P, or Zn; and a remainder of Sn.

4. The solder paste of claim 1, wherein the first solder alloy powder is 89Sn3.8Ag0.7Cu3.5Sb0.5Bi2.5In or 86.75n3.2Ag0.7Cu5.55b3.2Bi0.5In0.2Ni.

5. The solder paste of claim 1, wherein the second solder alloy powder is 91.0Sn2.5Ag0.5Cu6.0Bi, 93.5Sn3.0Ag0.5Cu3.0Bi or 93.5Sn3.0Ag0.5Cu6.0Bi.

6. The solder paste of claim 1, wherein the first solder alloy powder is 86.7Sn3.2Ag0.7Cu5.5Sb3.2Bi0.51n0.2Ni, and the second solder alloy powder is 91.0Sn2.5Ag0.5Cu6.0Bi.

7. The solder paste of claim 1, wherein the solder powder consists of 10 wt% to less than 50 wt% of the first solder alloy powder, and greater than 50 wt% to 90 wt% of the second solder alloy powder.

8. The solder paste of claim 7, wherein the solder powder consists of 20 wt% to 40 wt% of the first solder alloy powder, and 60 wt% to 80 wt% of the second solder alloy powder.

9. A method, comprising:
applying the solder paste of any one of claims 1-8 between two components to form an assembly; and
reflow soldering the assembly to form a solder joint from the solder paste.

10. The method of claim 9, wherein reflow soldering the assembly to form the solder joint, comprises: reflow soldering the assembly at a peak temperature lower than required to form a solder joint from a solder paste consisting of the first solder alloy powder and the flux.

11. The method of claim 10, wherein:
the first solder alloy powder has a solidus temperature of 210°C to 245°C; and
the second solder alloy powder has a solidus temperature of 200°C to 217°C.

12. The method of claim 11, wherein the peak temperature is below 245°C.

## Patentansprüche

1. Lötpaste, umfassend:
Lötpulver, das aus Folgendem besteht:
10 Gew.-% bis 90 Gew.-% eines ersten Lötlegierungspulvers, wobei das erste Lötlegierungspulver aus 1,5-4,0 Gew.-% Ag; 0,5-1,2 Gew.-% Cu; 3,0-6,5 Gew.-% Sb; 0,2-7,0 Gew.-% Bi; 0,1-3,5 Gew.-% In; optional 0,001-3,0 Gew.-% Ni, Co, Mn, P oder Zn; und einem Rest an Sn besteht; und
10 Gew.-% bis 90 Gew.-% eines zweiten Lötlegierungspulvers, wobei das zweite Lötlegierungspulver eine niedrigere Solidustemperatur als das erste Lötlegierungspulver aufweist und das zweite Lötlegierungspulver aus 1,5-4,0 Gew.-% Ag, 0,5-1,2 Gew.-% Cu, 1,0-7,0 Gew.-% Bi und einem Rest an Sn besteht; und einem Flussmittel.

2. Lötpaste nach Anspruch 1, wobei
(i) das erste Lötlegierungspulver eine Solidustemperatur von 210 °C bis 245 °C aufweist; und
(ii) das zweite Lötlegierungspulver eine Solidustemperatur von 200 °C bis 217 °C aufweist.

3. Lötpaste nach Anspruch 1, wobei das erste Lötlegierungspulver 1,5-4,0 Gew.-% Ag; 0,5-1,2 Gew.-% Cu; 3,0-6,5 Gew.-% Sb; 0,2-7,0 Gew.-% Bi; 0,1-3,5 Gew.-% In; 0,001-3,0 Gew.-% Ni, Co, Mn, P oder Zn; und ein Rest an Sn ist.

4. Lötpaste nach Anspruch 1, wobei das erste Lötlegierungspulver 89Sn3.8Ag0.7Cu3.5Sb0.5Bi2.5ln oder 86.7Sn3.2Ag0.7Cu5.5Sb3.2Bi0.5ln0.2Ni ist.

5. Lötpaste nach Anspruch 1, wobei das zweite Lötlegierungspulver 91.0Sn2.5Ag0.5Cu6.0Bi, 93.5Sn3.0Ag0.5Cu3.0Bi oder 93.5Sn3.0Ag0.5Cu6.0Bi ist.

6. Lötpaste nach Anspruch 1, wobei das erste Lötlegierungspulver 86.7Sn3.2Ag0.7Cu5.5Sb3.2Bi0.5ln0.2Ni ist und das zweite Lötlegierungspulver 91.0Sn2.5Ag0.5Cu6.0Bi ist.

7. Lötpaste nach Anspruch 1, wobei das Lötpulver aus 10 Gew.-% bis weniger als 50 Gew.-% des ersten Lötlegierungspulvers und mehr als 50 Gew.-% bis 90 Gew.-% des zweiten Lötlegierungspulvers besteht.

8. Lötpaste nach Anspruch 7, wobei das Lötpulver aus 20 Gew.-% bis 40 Gew.-% des ersten Lötlegierungspulvers und 60 Gew.-% bis 80 Gew.-% des zweiten Lötlegierungspulvers besteht.

9. Verfahren, umfassend:
Auftragen der Lötpaste nach einem der Ansprüche 1-8 zwischen zwei Komponenten, um eine Baugruppe auszubilden; und
Wiederaufschmelzlöten der Baugruppe, um eine Lötverbindung aus der Lötpaste auszubilden.

10. Verfahren nach Anspruch 9, wobei das Wiederaufschmelzlöten der Baugruppe, um die Lötverbindung auszubilden, Folgendes umfasst: Wiederaufschmelzlöten der Baugruppe bei einer Spitzentemperatur, die niedriger als erforderlich ist, um eine Lötverbindung aus einer Lötpaste auszubilden, die aus dem ersten Lötlegierungspulver und dem Flussmittel besteht.

11. Verfahren nach Anspruch 10, wobei:
das erste Lötlegierungspulver eine Solidustemperatur von 210 °C bis 245 °C aufweist; und
das zweite Lötlegierungspulver eine Solidustemperatur von 200 °C bis 217 °C aufweist.

12. Verfahren nach Anspruch 11, wobei die Spitzentemperatur unter 245 °C liegt.

## Revendications

1. Pâte à braser, comprenant :
une poudre de brasure constituée de :
10 % en poids à 90 % en poids d'une première poudre d'alliage de brasure, la première poudre d'alliage de brasure étant constituée de 1,5 à 4,0 % en poids d'Ag ; 0,5 à 1,2 % en poids de Cu ; 3,0 à 6,5 % en poids de Sb ; 0,2 à 7,0 % en poids de Bi ; 0,1 à 3,5 % en poids d'In ; éventuellement, 0,001 à 3,0 % en poids de Ni, Co, Mn, P, ou Zn ; et d'un reste de Sn ; et
10 % en poids à 90 % en poids d'une seconde poudre d'alliage de brasure, la seconde poudre d'alliage de brasure ayant une température de solidus inférieure à celle de la première poudre d'alliage de brasure, et la seconde poudre d'alliage de brasure étant constituée de 1,5 à 4,0 % en poids d'Ag, 0,5 à 1,2 % en poids de Cu, 1,0 à 7,0 % en poids de Bi, et d'un reste de Sn ; et du flux.

2. Pâte à braser selon la revendication 1, dans laquelle
(i) la première poudre d'alliage de brasure a une température de solidus de 210 °C à 245 °C ; et
(ii) la seconde poudre d'alliage de brasure a une température de solidus de 200 °C à 217 °C.

3. Pâte à braser selon la revendication 1, dans laquelle la première poudre d'alliage de brasure est 1,5 à 4,0 % en poids d'Ag ; 0,5 à 1,2 % en poids de Cu ; 3,0 à 6,5 % en poids de Sb ; 0,2 à 7,0 % en poids de Bi ; 0,1 à 3,5 % en poids d'In ; 0,001 à 3,0 % en poids de Ni, Co, Mn, P, ou Zn ; et un reste de Sn.

4. Pâte à braser selon la revendication 1, dans laquelle la première poudre d'alliage de brasure est 89Sn3,8Ag0,7Cu3,5Sb0,5Bi2,5In ou 86,7Sn3,2Ag0,7Cu5,5Sb3,2Bi0,5In0,2Ni.

5. Pâte à braser selon la revendication 1, dans laquelle la seconde poudre d'alliage de brasure est 91,0Sn2,5Ag0,5Cu6,0Bi, 93,5Sn3,0Ag0,5Cu3,0Bi ou 93,5Sn3,0Ag0,5Cu6,0Bi.

6. Pâte à braser selon la revendication 1, dans laquelle la première poudre d'alliage de brasure est 86,7Sn3,2Ag0,7Cu5,5Sb3,2Bi0,5In0,2Ni, et la seconde poudre d'alliage de brasure est 91,0Sn2,5Ag0,5Cu6,0Bi.

7. Pâte à braser selon la revendication 1, dans laquelle la poudre de brasure est constituée de 10 % en poids à moins de 50 % en poids de la première poudre d'alliage de brasure, et de plus de 50 % en poids à 90 % en poids de la seconde poudre d'alliage de brasure.

8. Pâte à braser selon la revendication 7, dans laquelle la poudre de brasure est constituée de 20 % en poids à 40 % en poids de la première poudre d'alliage de brasure, et de 60 % en poids à 80 % en poids de la seconde poudre d'alliage de brasure.

9. Procédé, comprenant :
l'application de la pâte à braser selon l'une quelconque des revendications 1 à 8 entre deux composants pour former un ensemble ; et
le brasage par refusion de l'ensemble pour former un joint de soudure à partir de la pâte à braser.

10. Procédé selon la revendication 9, dans lequel le brasage par refusion de l'ensemble pour former le joint de soudure, comprend : le brasage par refusion de l'ensemble à une température de crête inférieure à celle requise pour former un joint de soudure à partir d'une pâte à braser constituée de la première poudre d'alliage de brasure et du flux.

11. Procédé selon la revendication 10, dans lequel :
la première poudre d'alliage de brasure a une température de solidus de 210 °C à 245 °C ; et
la seconde poudre d'alliage de brasure a une température de solidus de 200 °C à 217 °C.

12. Procédé selon la revendication 11, dans lequel la température de crête est en dessous de 245 °C.
